# FASCICULE DE BREVET EUROPEEN

(11) **EP 3 923 477 B1**
(45) Date de publication et mention de la délivrance du brevet: **18.10.2023**
(21) Numéro de dépôt: 21178337.8
(22) Date de dépôt: 08.06.2021
(51) Int. Cl.: H03K 17/689

(54) **DISPOSITIF DE COMMANDE D'INTERRUPTEUR**
VORRICHTUNG ZUR STEUERUNG EINES SCHALTERS
DEVICE FOR CONTROLLING A SWITCH

(30) Priorité: 09.06.2020 FR 2006028
(43) Date de publication de la demande: 15.12.2021
(73) Titulaire: Commissariat à l'Energie Atomique et aux Energies Alternatives, 75015 Paris (FR)
(72) Inventeur: BERGOGNE, Dominique, 38054 Grenoble Cedex 09 (FR); PHUNG, Thanh-Hai, 38054 Grenoble Cedex 09 (FR)
(74) Mandataire: Cabinet Beaumont

(56) Documents cités:
- DE-U1- 29 503 129
- US-A1- 2016 248 413

## Description

### Domaine technique

La présente description concerne de façon générale les dispositifs électroniques, en particulier la commande d'interrupteurs, plus particulièrement la commande d'interrupteurs de convertisseurs à découpage.

### Technique antérieure

Des interrupteurs commandés sont utilisés en particulier dans des convertisseurs à découpage. Les interrupteurs sont mis alternativement aux états passant et bloqué à une fréquence de découpage. On utilise des convertisseurs à découpage pour fournir une tension et/ou un courant, à partir d'une alimentation ayant des valeurs de tension/courant différentes des valeurs des tension/courant à fournir. Par exemple, un convertisseur à découpage de type alternatif-continu AC-DC (en anglais "Alternating Current-Direct Current") permet d'obtenir une tension continue à partir d'une tension alternative telle que celle d'un réseau électrique ou d'un alternateur.

Le document US-A-2016/0248413 décrit un dispositif de commande rapprochée ou driver.

Le document DE-U-29503129.8 décrit un agencement de circuit pour mettre sous tension et hors tension un circuit de charge en courant continu à l'aide de transistors à effet de champ.

### Résumé de l'invention

Il existe un besoin d'augmenter la fiabilité des convertisseurs à découpage connus.

Il existe un besoin de fournir une tension d'alimentation à un circuit appliquant des commandes à un interrupteur d'un convertisseur à découpage.

Il existe un besoin de commander plusieurs interrupteurs ayant des potentiels variables l'un par rapport à l'autre.

Un mode de réalisation pallie tout ou partie des inconvénients des convertisseurs à découpage connus.

Un mode de réalisation pallie tout ou partie des inconvénients des procédés connus de commande d'interrupteur, notamment d'interrupteur de convertisseur à découpage.

Un mode de réalisation pallie tout ou partie des inconvénients des circuits connus de commande d'interrupteur, notamment d'interrupteur de convertisseur à découpage.

Un mode de réalisation prévoit d'accélérer la vitesse de commutation applicable à un interrupteur par un circuit de commande connu, en particulier dans un convertisseur à découpage.

Un mode de réalisation prévoit d'accélérer la fréquence de découpage et/ou d'augmenter le niveau de fiabilité des convertisseurs à découpage connus.

Un mode de réalisation prévoit un procédé de commande d'au moins un interrupteur, comprenant :
la fourniture, par un module émetteur et à partir d'un premier signal en créneaux, représentatif de l'état souhaité dudit interrupteur et dont des cycles se répètent à une fréquence de découpage, de deuxièmes signaux en créneaux ayant tous une même fréquence, supérieure à la fréquence de découpage, lesdits deuxièmes signaux ayant entre eux au moins un déphasage dont la valeur est fonction de l'état du premier signal ;
la transmission desdits deuxièmes signaux à travers des éléments capacitifs fournissant des signaux déphasés ;
la réception, par un module récepteur, des signaux déphasés reproduisant ledit au moins un déphasage ;
la vérification, par le module récepteur, d'un état valide ou invalide dudit au moins un déphasage ;
l'obtention et la mémorisation, lorsque l'état dudit au moins un déphasage est valide, d'une valeur à partir desdits signaux déphasés, ladite valeur étant représentative de l'état souhaité dudit au moins un interrupteur ; et
l'application, audit au moins un interrupteur, de la valeur représentative obtenue si l'état dudit au moins un déphasage est valide ou de la valeur représentative mémorisée si l'état dudit au moins un déphasage est invalide.

Selon un mode de réalisation, ledit module émetteur est référencé à un premier potentiel, ledit module récepteur étant référencé à un deuxième potentiel variable par rapport au premier potentiel.

Selon un mode de réalisation, le deuxième potentiel est un potentiel de référence de commande dudit au moins un interrupteur.

Selon un mode de réalisation, un générateur d'une tension utilise une énergie véhiculée par lesdits signaux, le générateur comprenant, de préférence, un circuit redresseur.

Selon un mode de réalisation, le module émetteur est alimenté par ladite tension.

Selon un mode de réalisation, le générateur comprend un circuit d'écrêtage, de préférence comprenant une ou plusieurs diodes Zener et/ou un ou plusieurs transistors commandés par des ponts diviseurs recevant lesdits signaux.

Un mode de réalisation prévoit un circuit de commande d'au moins un interrupteur comportant :
au moins un circuit de commande rapprochée d'application, à une borne de commande dudit au moins un interrupteur, d'un signal de commande en créneaux dont des cycles se répètent à une fréquence de découpage ; et
un module récepteur de signaux déphasés en créneaux, représentatifs d'un état souhaité dudit au moins un interrupteur, la fréquence des cycles desdits signaux déphasés étant supérieure à la fréquence de découpage et au moins un déphasage entre lesdits signaux déphasés étant d'une valeur différente en fonction de l'état souhaité dudit au moins un interrupteur, le module récepteur fournissant, audit circuit de commande rapprochée, une valeur correspondant à une valeur obtenue et mémorisée à partir dudit au moins un déphasage lorsque l'état dudit au moins un déphasage est valide et à une valeur mémorisée si l'état dudit au moins un déphasage est invalide.

Selon un mode de réalisation, le circuit comporte un générateur d'une tension à partir d'une énergie véhiculée par lesdits signaux déphasés, le générateur comprenant un circuit d'écrêtage desdits signaux déphasés.

Selon un mode de réalisation, le circuit comporte deux portes logiques, réalisant chacune une fonction de type OU-Exclusif, comparant un premier signal déphasé respectivement à un deuxième et un troisième signal déphasé, l'état valide ou non valide dudit au moins un déphasage étant déterminé en fonction de résultats des comparaisons.

Selon un mode de réalisation, le circuit comporte en outre :
une première et une deuxième bascule ayant des entrées de données recevant respectivement lesdits deuxième et troisième signaux déphasés et des entrées d'horloge recevant les résultats respectifs des comparaisons opérées par lesdites portes logiques ; et
une troisième bascule de fourniture de ladite valeur représentative de l'état souhaité dudit au moins un interrupteur, la troisième bascule ayant une entrée d'horloge reliée à une sortie de la deuxième bascule et une entrée de donnée reliée à une sortie de la troisième bascule.

Un mode de réalisation prévoit un système de commande d'au moins un interrupteur comportant :
un module émetteur de fourniture, à partir d'un premier signal en créneaux représentatif de l'état souhaité dudit interrupteur et dont des cycles se répètent à une fréquence de découpage, de deuxièmes signaux en créneaux ayant tous une même fréquence, supérieure à la fréquence de découpage, lesdits deuxièmes signaux ayant entre eux au moins un déphasage d'une valeur différente en fonction de l'état du premier signal ;
un circuit de commande dudit interrupteur tel que décrit ; et
des élément capacitifs de transmission desdits deuxièmes signaux audit circuit de commande sous la forme desdits signaux déphasés.

Selon un mode de réalisation, le système est configuré pour mettre en oeuvre le procédé décrit.

Un mode de réalisation prévoit un dispositif comprenant un système tel que défini ci-dessus et ledit au moins un interrupteur, ledit au moins un interrupteur étant de préférence de type HEMT, plus préférentiellement à GaN.

Un mode de réalisation prévoit un dispositif monolithique comprenant un circuit tel que défini ci-dessus ou un dispositif tel que défini ci-dessus.

Un mode de réalisation prévoit un convertisseur à découpage comprenant un ou plusieurs systèmes tels que définis ci-dessus, et/ou un ou plusieurs dispositifs tels que définis ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un exemple de cellule de commutation d'un convertisseur d'un type auquel s'appliquent les modes de réalisation décrits ;
la figure 2 représente, de manière schématique, un exemple d'un mode de réalisation d'un circuit de commande d'interrupteur ;
la figure 3 représente, de manière schématique, un exemple d'un mode de réalisation d'une partie du circuit de commande de la figure 2 ;
la figure 4 représente, sous forme de chronogrammes schématiques, des allures de signaux dans un exemple de procédé de commande d'interrupteur mis en oeuvre par le circuit de la figure 2, selon un mode de réalisation ;
la figure 5 représente, de manière schématique, un exemple d'un mode de réalisation d'une autre partie du circuit de la figure 2 ;
la figure 6 représente, sous forme de chronogrammes schématiques, des allures d'autres signaux dans un exemple de mode de réalisation d'un procédé de commande d'interrupteur mis en oeuvre par le circuit de la figure 2 ;
la figure 7 représente, de manière schématique, un exemple d'un mode de réalisation d'encore une autre partie du circuit de la figure 2 ;
la figure 8 représente, de manière schématique, un exemple de circuit du mode de réalisation de la figure 7 ; et
la figure 9 représente, de manière partielle et schématique, une variante de réalisation du circuit de la figure 8.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les structures de convertisseur à découpage et les procédés de génération de signaux représentatifs d'états souhaités d'interrupteurs de convertisseur à découpage ne sont pas décrits en détail, les modes de réalisation étant compatibles avec tous ou la plupart des convertisseurs à découpage usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

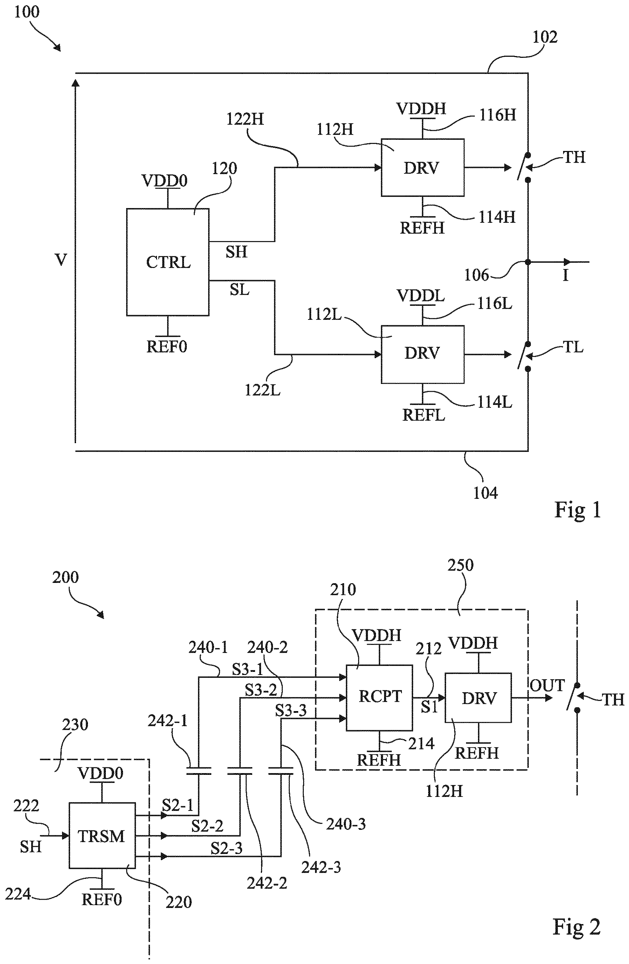

La figure 1 représente, de manière schématique, un exemple de cellule de commutation 100 d'un convertisseur d'un type auquel s'appliquent les modes de réalisation décrits.

La cellule de commutation 100 comprend l'association de deux interrupteurs TH et TL électriquement en série entre des noeuds 102 et 104. Les interrupteurs TH et TL sont commandés en sorte que, lorsque l'un des interrupteurs TH et TL est passant, l'autre des interrupteurs TH et TL est bloqué. Ainsi, les interrupteurs TH et TL ne sont pas passants simultanément. Les interrupteurs TH et TL peuvent aussi être bloqués simultanément. Chacun des interrupteurs TH et TL est passant à tour de rôle, définissant ainsi des commutations entre un état passant de l'un des interrupteurs TH et TL, et un état passant de l'autre des interrupteurs TH et TL.

Les interrupteurs TH et TL comprennent typiquement des transistors à effet de champ. Chaque interrupteur TH, TL peut comprendre, ou être constitué par, un transistor ou plusieurs transistors en série et/ou en parallèle. Cet interrupteur a alors des bornes de source et de drain correspondant respectivement à des bornes de source et de drain du ou des transistors. Chaque interrupteur TH, TL a une borne de commande définie, dans le cas d'interrupteurs comprenant un ou des transistors, par une borne de grille du ou des transistors. L'état passant/bloqué de l'interrupteur est obtenu en appliquant une tension entre la borne de commande et une borne de référence de l'interrupteur, par exemple une borne de source ou de drain. Autrement dit, on applique à la borne de commande une tension référencée par rapport au potentiel de la borne de référence.

De préférence, les interrupteurs TH et TL sont de type HEMT, c'est-à-dire qu'ils comprennent des transistors de type dit transistor à haute mobilité électronique HEMT ("High Electron Mobility Transistor"). Ce type de transistor réalise, à son état passant, une conduction entre drain et source par une interface entre semiconducteurs à grande largeur de bande interdite (en anglais "wide bandgap"), les électrons étant mobiles le long de ladite interface. Ces semiconducteurs peuvent être du nitrure de gallium GaN et du nitrure d'aluminium-gallium AlGaN. On parle alors de transistor de type HEMT à GaN. Des transistors HEMT permettent de bloquer des tensions plus élevées et permettent des commutations plus rapides que d'autres types de transistors à effet de champ.

Le convertisseur dans lequel se trouve la cellule de commutation 100 reçoit ou fournit une tension V. Le convertisseur reçoit ou fournit un courant I sur un noeud 106 de connexion en série des interrupteurs TH et TL. Le courant I est reçu ou fourni par des éléments non représentés du convertisseur. Le courant I est par exemple dans une inductance, non représentée, interne au convertisseur. La structure du convertisseur n'est pas détaillée ici, les modes de réalisation décrits étant compatibles avec les convertisseurs à découpage usuels.

Dans une application typique, la tension V est une tension alternative provenant d'un réseau de distribution électrique. La tension V a alors, par exemple, une tension efficace de l'ordre d'environ 110 V ou d'environ 230 V, et par exemple une fréquence égale à 50 Hz ou 60 Hz. Le convertisseur fournit une tension continue, obtenue à partir du courant I par des parties non représentées du convertisseur. La tension continue est typiquement utilisée pour charger une batterie, par exemple une batterie d'un ordinateur portable ou d'un dispositif mobile de communication à distance tel qu'un téléphone mobile. Plus particulièrement, la charge de la batterie peut être réalisée par l'intermédiaire d'une connexion de type bus universel en série USB (en anglais "Universal-Serial-Bus") de préférence à fourniture de puissance (en anglais "Power-Delivery").

Des signaux SH et SL de commande des interrupteurs respectifs TH et TL sont appliqués aux bornes de commande des interrupteurs respectifs TH et TL par l'intermédiaire de circuits, respectivement 112H et 112L, de commande rapprochée (DRV - en anglais "driver") dits aussi circuits d'attaque ou circuits de contrôle de grille de transistor. Chaque signal SH, SL a des niveaux bas et haut correspondant à des états souhaités respectifs, par exemple bloqué et passant, de l'interrupteur TH, TL concerné. Autrement dit, les signaux SH et SL prennent des valeurs représentatives des états des interrupteurs respectifs TH, TL.

Le circuit de commande rapprochée 112H est typiquement alimenté par une tension VDDH référencée par rapport à un potentiel REFH, et le circuit de commande rapprochée 112L est typiquement alimenté par une tension VDDL référencée par rapport à un potentiel REFL. Par tension référencée par rapport à un potentiel, ou tension référencée à ce potentiel, on entend que ce potentiel est appliqué à un premier noeud (borne 114H, 114L dans les circuits respectifs 112H, 112L) et que cette tension est appliquée entre un deuxième noeud (borne 116H, 116L dans les circuits respectifs 112H, 112L) et le premier noeud. Les potentiels REFH et REFL constituent ainsi des potentiels de référence des commandes des interrupteurs respectifs TH et TL.

Les potentiels REFH et REFL sont généralement différents. Par exemple ce sont les potentiels des bornes de source des interrupteurs respectifs TH, TL. Plus précisément, les potentiels REFH et REFL sont généralement variables l'un par rapport à l'autre (c'est-à-dire que leur différence varie) en relation avec le découpage et/ou en relation avec les variations de la tension V lorsque celle-ci est alternative.

Les signaux SH et SL sont typiquement en créneaux. Par signal en créneaux, on entend un signal comprenant une succession de cycles, chaque cycle étant constitué d'une partie à un niveau bas du signal et d'une partie à un niveau haut du signal. Les cycles des signaux SH et SL sont répétés à une fréquence de découpage. Ainsi, à la fréquence de découpage, on rend alternativement l'interrupteur TH passant et l'interrupteur TL bloqué, puis l'interrupteur TL passant et l'interrupteur TH bloqué. La fréquence de découpage est par exemple inférieure, ou égale, à 1 MHz.

Les signaux SH et SL sont typiquement fournis par un circuit 120 (CTRL) de génération de signaux. Le circuit 120 est relié aux circuits 112H et 112L par des liaisons respectives 122H et 122L. Le circuit 120 peut comprendre une unité de traitement séquentiel de données, telle qu'un microprocesseur, mettant en oeuvre un procédé de génération de signaux pour obtenir le fonctionnement souhaité du convertisseur à découpage. Ce procédé n'est pas décrit en détail, les modes de réalisation décrits étant compatibles avec les procédés usuels de génération de signaux de commande d'interrupteurs de convertisseur à découpage.

Le circuit 120 de génération de signaux est typiquement alimenté par une tension VDD0 référencée par rapport à un potentiel REFO, par exemple une masse. Le potentiel REFO est différent des potentiels REFH et/ou REFL. Plus précisément, les potentiels REFH et/ou REFL varient généralement par rapport au potentiel REFO en relation avec le découpage et/ou en relation avec les variations de la tension V lorsque celle-ci est alternative.

Les liaisons 122H et 122L comprennent chacune des moyens, non représentés, pour transmettre les signaux respectifs SH et SL, en changeant leur référence de potentiel, entre le circuit 120 de génération de signaux et les circuits de commande rapprochée respectifs 112H et 112L.

Cependant, la transmission des signaux SH et SL par les liaisons respectives 122H et 122L pose diverses difficultés liées aux variations entre les potentiels REFH et/ou REFL et/ou REFO. A titre d'exemple, les variations des potentiels REFH et/ou REFL et/ou REFO l'un par rapport à l'autre ont une amplitude supérieure à 300 V, par exemple de l'ordre de 500 V. A titre d'exemple, ces variations sont rapides, c'est-à-dire se produisent à une vitesse (souvent notée dV/dt) atteignant ou dépassant temporairement 50 V/ns (par exemple à chaque commutation). Ces variations rapides peuvent être la source d'erreurs dans la transmission des signaux SH et SL par les liaisons 122H et 122L.

Plus le découpage est rapide, plus ces difficultés sont grandes. Les modes de réalisation décrits prévoient, en particulier, de résoudre au moins une partie de ces difficultés.

Les modes de réalisation décrits sont applicables à tout convertisseur à découpage. En particulier, le convertisseur peut fournir et/ou recevoir une tension alternative monophasée ou multiphasée. Les modes de réalisation décrits sont également applicables à tout convertisseur comprenant, entre deux noeuds d'application d'une tension, par exemple alternative, ou d'application d'une phase d'une tension alternative multiphasée, une ou plusieurs branches en parallèle chacune constituée d'une cellule de commutation comprenant au moins deux interrupteurs en série. Ainsi, le convertisseur peut fournir une tension, par exemple alternative multiphasée, à un moteur et/ou recevoir une tension alternative multiphasée en provenance d'un alternateur.

La figure 2 représente, de manière schématique, un exemple d'un mode de réalisation d'un circuit de commande 200 d'interrupteur.

Le circuit de commande 200 est, de préférence, compris dans une cellule de commutation d'un convertisseur, telle que la cellule 100 décrite ci-dessus en relation avec la figure 1. Dans l'exemple représenté, le circuit de commande 200 est utilisé pour commander l'interrupteur TH de la cellule de commutation 100. Plus précisément, le circuit de commande 200 applique un signal OUT à la borne de commande de l'interrupteur commandé. Le circuit de commande 200 comprend alors un circuit de commande rapprochée (DRV) 112H du type de celui décrit en relation avec la figure 1, alimenté par la tension VDDH et fournissant le signal OUT appliqué à la borne de commande de l'interrupteur TH (figure 1).

Une partie du circuit de commande 200 est référencée au potentiel REFH de commande de l'interrupteur TH et comprend le circuit de commande rapprochée 112H et un circuit, ou module, 210 (RCPT). Par circuit référencé à un potentiel, on entend que les tensions de ce circuit en fonctionnement sont référencées par rapport à ce potentiel. Le module 210 fournit au circuit de commande rapprochée 112H un signal de commande S1 à appliquer à l'interrupteur TH. Autrement dit, le signal de commande S1 véhicule une valeur représentative d'un état de l'interrupteur TH, cette valeur étant à appliquer à l'interrupteur TH. Le module 210 est alimenté, par exemple, par la tension VDDH. Le signal S1 est référencé au potentiel REFH, autrement dit, le signal S1 est appliqué à un noeud ou borne 212, le potentiel REFH est appliqué à un noeud ou borne 214, et la valeur prise par le signal S1 est fonction de la tension entre le noeud 212 et le noeud 214.

De préférence, une autre partie du circuit de commande 200 est référencée au potentiel REFO d'un circuit de génération de signaux du type du circuit 120 décrit en relation avec la figure 1, et constitue un circuit, ou module, 220 (TRSM). Autrement dit, les circuits de génération de signaux 120 et le module 220 font partie d'un ensemble ou bloc émetteur 230 référencé par rapport au même potentiel REFO. Le module 220 est alimenté par exemple par la tension VDD0. Le module 220 reçoit le signal SH de commande de l'interrupteur TH. Le signal SH est référencé au potentiel REFO, autrement dit, le signal SH est appliqué à un noeud ou borne 222, le potentiel REFO est appliqué à un noeud ou borne 224, et la valeur prise par le signal SH est fonction de la tension entre le noeud 222 et le noeud 224.

Le circuit de commande 200 comprend plusieurs liaisons 240-i. L'indice i varie entre 1 et le nombre N de liaisons. De préférence, le nombre N de liaisons est égal à trois, et le circuit de commande 200 comprend alors trois liaisons 240-1, 240-2, et 240-3. Le nombre de liaisons peut cependant être égal à deux ou être supérieur à trois.

Un mode de réalisation d'une cellule de commutation peut différer de la cellule de commutation 100 de la figure 1 en ce que les liaisons 240-i et les modules 210 et 220 remplacent la liaison 122H (figure 1).

De préférence, chacune des liaisons 240-i comprend un élément capacitif 242-i (242-1, 242-2, 242-3) ayant ses bornes reliées, de préférence connectées, respectivement aux modules 210 et 220. Chaque élément capacitif 242-i peut comprendre un condensateur ou plusieurs condensateurs en série ou en parallèle.

Les modes de réalisation de convertisseurs à découpage ne se limitent pas à l'exemple représenté en figure 2. Un circuit de commande du type de l'exemple représenté peut également remplacer la liaison 122L (figure 1) et être utilisé pour commander l'interrupteur TL (figure 1). Ce circuit de commande est similaire au circuit 200, à la différence que la tension VDDH référencée au potentiel REFH est remplacée par la tension VDDL référencée au potentiel REFL, le circuit 112H est remplacé par un circuit de commande rapprochée 112L du type de celui de la figure 1, et le signal SH est remplacé par le signal SL (figure 1). La prévision de circuits de commande identiques ou similaires pour les interrupteurs TH et TL permet que des délais liés à des temps de propagation de signaux soient identiques dans les deux circuits de commande, ce qui facilite la génération des signaux SL et SH.

Plus généralement, on peut prévoir un circuit de commande tel que le circuit 200 dans tout dispositif comprenant un interrupteur recevant une commande référencée à un premier potentiel, tel que le potentiel REFH de l'exemple représenté, ce dispositif recevant un signal, tel que le signal SH, représentatif d'un état souhaité de l'interrupteur et référencé à un deuxième potentiel tel que le potentiel REFO.

De préférence, l'ensemble du module 210 et du circuit de commande rapprochée 112H forme un circuit monolithique 250, ou est compris dans un dispositif monolithique comprenant en outre, éventuellement, l'interrupteur TH. Plus préférentiellement, le circuit de commande 200 est compris dans un dispositif monolithique. Par dispositif monolithique, on entend que tous les circuits du dispositif sont intégrés dans et sur un même substrat ou support, typiquement dans et sur une même portion de tranche ou plaquette (en anglais "wafer") semiconductrice. Un tel dispositif, ou circuit intégré, monolithique est, de préférence, situé dans un boîtier de circuit intégré. Par boîtier de circuit intégré, on entend un ensemble, de préférence étanche, d'où sortent des plages de connexion ou des broches de connexion à des circuits électroniques extérieurs au boîtier, par exemple à un circuit imprimé, PCB (en anglais "Printed Circuit Board"). Par rapport à un dispositif comprenant plusieurs circuits monolithiques, ceci permet une mise en oeuvre plus facile, en particulier pour réaliser une cellule de commutation.

Un avantage est que les liaisons 240-i isolent galvaniquement les modules 210 et 220 l'un de d'autre. Ceci permet, en particulier, de commander plusieurs interrupteurs (par exemple d'un convertisseur) ayant des potentiels variables l'un par rapport à l'autre, à partir d'un même circuit de génération de signaux de commande. Dans des variantes, chaque liaison 240-i peut comprendre, en plus ou en remplacement de l'élément capacitif 242-i, un ou des éléments tel qu'un transformateur, un élément inductif, ou un optocoupleur. Cependant, par rapport à ces variantes, les liaisons par les seuls éléments capacitifs 242-i présentent l'avantage de simplifier l'obtention de l'isolation galvanique et/ou l'obtention d'un dispositif monolithique comprenant le circuit de commande 200.

En fonctionnement, le module 220 du bloc émetteur 230 fournit les signaux S2-1 (S2-1, S2-2, S2-3) sur les liaisons respectives 240-i. Autrement dit, pour chaque liaison 240-i, le module 220 fournit le signal S2-i sur une sortie reliée au module 210 par cette liaison 240-i. A leur sortie du module 220, les signaux sont référencés au potentiel REFO.

Au moins deux des signaux S2-1, par exemple les signaux S2-2 et S2-3, sont déphasés l'un par rapport à l'autre. Le déphasage entre ces deux signaux est fonction du niveau du signal SH de commande de l'interrupteur TH. Autrement dit, le déphasage entre les signaux, par exemple S2-2 et S2-3, est représentatif de l'état passant/bloqué souhaité de l'interrupteur TH. Par exemple, le signal S2-2 est en avance de phase par rapport au signal S2-3 lorsque l'état souhaité de l'interrupteur TH est bloqué, et le signal S2-2 est en retard de phase par rapport au signal S2-3 lorsque l'état souhaité de l'interrupteur TH est passant.

Pour cela, les signaux S2-i ont, de préférence, une fréquence supérieure à la fréquence de découpage, par exemple supérieure, ou égale, à 10 fois la fréquence de découpage, par exemple supérieure, ou à égale, à 10 MHz.

Les signaux S2-i sont transmis par les liaisons 240-i respectives. Cette transmission est effectuée, de préférence, par l'intermédiaire des éléments capacitifs 242-i.

Les signaux S2-i, après avoir été véhiculés par les liaisons respectives 240-i, correspondent à des signaux respectifs S3-i reçus par le module 210. Les signaux S3-i sont référencés au potentiel REFH. En l'absence d'erreur de transmission, les signaux S3-i ont entre eux des déphasages identiques aux déphasages respectifs entre les signaux S2-i.

La transmission des signaux S2-i et la réception des signaux S3-i avec changement de potentiel de référence est, de préférence, obtenue grâce aux éléments capacitifs 242-i. En l'absence d'erreur au cours de la transmission, les signaux S3-i diffèrent alors des signaux S2-i respectifs seulement par leur référence au potentiel REFH. Autrement dit, les signaux S2-i et S3-i constituent des mêmes signaux transmis par les éléments capacitifs 242-i et reçus par le module 210.

A partir du déphasage entre deux des signaux S3-i, par exemple à partir du déphasage entre les signaux S3-2 et S3-3, le module 210 obtient la valeur représentative de l'état souhaité de l'interrupteur TH initialement véhiculée par le signal SH. Cette valeur représentative correspond au niveau du signal S1 fourni par le module 210 au circuit de commande rapprochée 112H. Cette valeur représentative est appliquée à l'interrupteur TH par le circuit de commande rapprochée 112H.

Par exemple, lorsque le signal S3-2 est en avance de phase par rapport au signal S3-3, le signal S1 est à un niveau de mise à l'état bloqué de l'interrupteur TH, et lorsque le signal S3-2 est en retard de phase par rapport au signal S3-3, le signal S1 est à un niveau de mise à l'état passant de l'interrupteur TH.

La valeur représentative de l'état souhaité de l'interrupteur TH peut ainsi être appliquée à l'interrupteur TH alors que les potentiels de référence REFH et REFO des circuits respectifs 210 et 220 varient l'un par rapport à l'autre. Ceci permet, en particulier, que tous les signaux de commande des interrupteurs du convertisseur, tels que les signaux SH et SL, soient générés par le même circuit 120 (figure 1) référencé au potentiel REFO.

Les signaux S2-i sont des signaux variables, en créneaux, dont les valeurs alternent entre des niveaux respectivement haut "1" et bas "0". Tous les signaux ont la même fréquence (de répétition des créneaux) et sont générés par le module 220 en étant déphasés les uns par rapport aux autres d'une valeur fonction de la valeur ou état "0" ou "1" du signal SH. La fréquence des signaux S2-i est supérieure à la fréquence de découpage (de répétition des créneaux du signal SH). Les signaux S2-i, devenus S3-i après découplage capacitif, sont traités par le module 210 qui détecte l'état du déphasage entre ces signaux et génère le signal S1. Le signal S1 reprend les états successifs du signal SH pour commander, en tout ou rien, l'interrupteur TH.

Bien que, dans l'exemple décrit ci-dessus, seul l'interrupteur TH soit commandé par le circuit de commande 200, on peut prévoir un circuit de commande similaire au circuit de commande 200 pour commander plusieurs interrupteurs. La commande de ces interrupteurs est par exemple référencée à un même potentiel. Pour cela, le circuit de commande peut recevoir plusieurs signaux de commande tels que le signal de commande SH. Le circuit de commande peut alors transmettre au moins trois signaux S2-i (correspondant, à leur réception, à au moins trois signaux S3-i) présentant entre eux plusieurs déphasages représentatifs des états souhaités respectifs des interrupteurs.

L'exemple décrit ci-dessus, dans lequel les potentiels REFO et REFH des circuits sont variables l'un par rapport à l'autre, n'est pas limitatif, et on peut également prévoir que les potentiels soient fixes l'un par rapport à l'autre, par exemple à des niveaux différents.

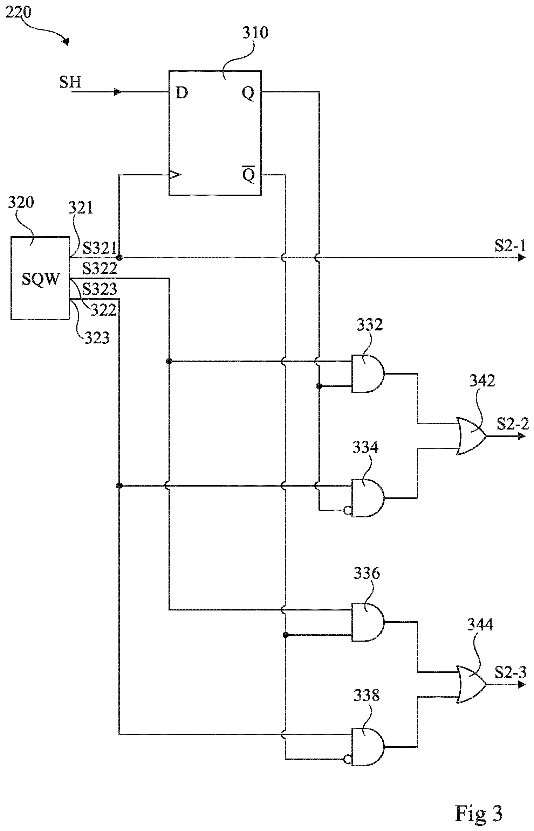

La figure 3 représente, de manière schématique, un exemple d'un mode de réalisation du module 220 de fourniture des signaux S2-i du circuit de commande 200 de la figure 2.

Le module 220 peut comprendre une bascule 310 de type D (en anglais "flip-flop"). Une telle bascule comprend une entrée de donnée D, une entrée d'horloge et une sortie Q, et peut comprendre une sortie Q̅ prenant un niveau inversé par rapport à celui de la sortie Q. La bascule 310 reçoit le signal SH.

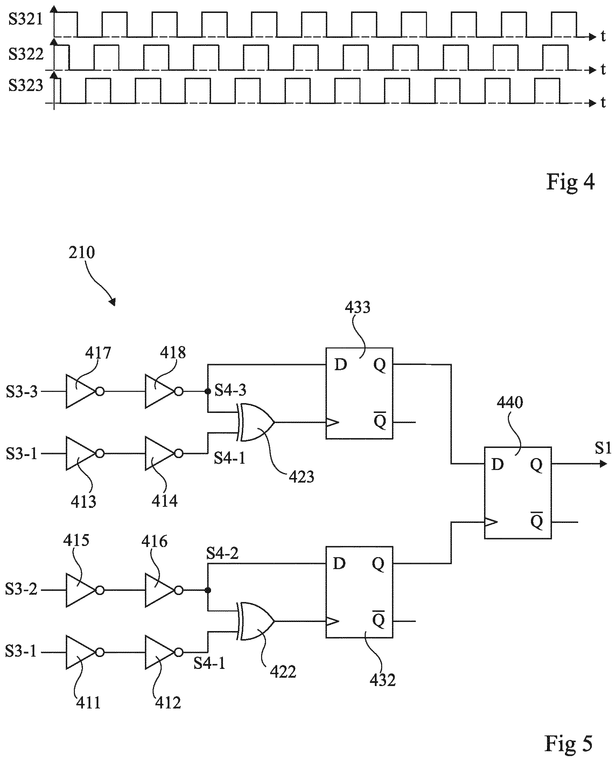

Le module 220 peut comprendre un générateur de signaux 320 (SQW). Plus précisément, trois signaux S321, S322 et S323 de même fréquence et déphasés les uns par rapport aux autres sont fournis par le générateur 320 sur des sorties respectives 321, 322 et 323. Un exemple de signaux fournis par le générateur 320 est décrit ci-après en relation avec la figure 4.

Le signal S2-1 est fourni par le générateur 320 sur la sortie 321 et constitue le signal S321 fourni par le module 220. L'entrée d'horloge de la bascule 310 est reliée, de préférence connectée, à la sortie 321, et reçoit donc le signal S2-1.

Le module 220 peut comprendre une porte logique ET 332 ayant une entrée reliée, de préférence connectée, à la sortie 322, et une autre entrée reliée, de préférence connectée, à la sortie Q de la bascule 310.

Le module 220 peut comprendre une porte logique ET 334 ayant une entrée reliée, de préférence connectée, à la sortie 323, et une entrée inverseuse reliée, de préférence connectée, à la sortie Q de la bascule 310.

Le module 220 peut comprendre une porte logique ET 336 ayant une entrée reliée, de préférence connectée, à la sortie 323, et une autre entrée reliée, de préférence connectée, à la sortie inversée Q̅ de la bascule 310.

Le module 220 peut comprendre une porte logique ET 338 ayant une entrée reliée, de préférence connectée, à la sortie 324, et une entrée inverseuse reliée, de préférence connectée, à la sortie inversée Q̅ de la bascule 310.

Le module 220 peut comprendre une porte logique OU 342 ayant deux entrées reliées, de préférence connectées, aux sorties des portes ET respectives 332 et 334. La porte logique OU 342 fournit, sur sa sortie, le signal S2-2.

Le module 220 peut comprendre une porte logique OU 344 ayant deux entrées reliées, de préférence connectées, aux sorties des portes ET respectives 336 et 338. La porte logique OU 344 fournit, sur sa sortie, le signal S2-3.

Bien que ceci ne soit pas représenté, la bascule 310, le générateur 320, les portes logiques ET 332, 334, 336, 338, et les portes logiques OU 342 et 344 sont alimentées par la tension VDD0 (figure 2) référencée au potentiel REFO.

En fonctionnement, lorsque le signal SH est à un niveau haut, par exemple lors d'un front montant du signal S2-1, la sortie non inverseuse de la bascule 310 passe à un niveau haut et la sortie inverseuse de la bascule 310 passe à un niveau bas. Les sorties des portes ET 334 et 336 restent au niveau bas, et les sorties des portes ET 332 et 338 prennent les niveaux logiques des sorties respectives 322 et 323. Les signaux S2-2 et S2-3 prennent les niveaux logiques des sorties respectives 322 et 323.

Lorsque le signal SH est à un niveau bas, par exemple lors d'un front montant du signal S2-1, la sortie non inverseuse de la bascule 310 passe au niveau bas et la sortie inverseuse de la bascule 310 passe au niveau haut. Les sorties des portes ET 332 et 338 sont au niveau bas, et les sorties des portes ET 334 et 336 prennent les niveaux logiques des sorties respectives 323 et 322. Les signaux S2-2 et S2-3 prennent les niveaux logiques des sorties respectives 323 et 322.

Ainsi, les signaux S2-2 et S2-3 prennent les niveaux logiques des sorties respectives 322 et 323 lorsque le signal SH est au niveau haut, et des sorties respectives permutées 323 et 322 lorsque le signal SH est au niveau bas. Du fait que les signaux présents sur les sorties 322 et 323 sont déphasés, il en résulte que le déphasage entre les signaux S2-2 et S2-3 prend des valeurs opposées pour les deux niveaux, bas et haut, du signal de commande SH.

L'exemple particulier du module 220 décrit ci-dessus n'est pas limitatif. Le module 220 peut être constitué par tout dispositif permettant de générer des signaux entre lesquels un déphasage prend des valeurs différentes pour les niveaux bas et haut du signal de commande SH. En particulier, la bascule 310, les portes logiques ET 332, 334, 336, 338, et les portes logiques OU 342 et 344 peuvent être remplacées par tout circuit adapté à fournir des signaux prenant les niveaux logiques des sorties respectives 322 et 323 lorsque le signal SH est au niveau haut, et des sorties respectives permutées 323 et 322 lorsque le signal SH est au niveau bas. Le générateur 320 peut être remplacé par un générateur de seulement deux signaux ou de plus de trois signaux.

De préférence, les sorties du module 220 fournissant les signaux S2-i présentent chacune une impédance interne (non représentée) apte, lors des variations des potentiels REFH et REFO l'un par rapport à l'autre, à maintenir des valeurs de tension des signaux S2-i dans une plage de tension nominale. Autrement dit, le module 220 est en mesure d'absorber des pics de courant de charge/décharge des éléments capacitifs 242-i lors de ces variations, y compris lors des variations rapides. Ceci peut être mis en oeuvre par tout composant utilisé usuellement pour absorber un pic de courant, par exemple un élément capacitif.

La figure 4 représente, sous forme de chronogrammes schématiques, des allures de signaux dans un exemple de procédé de commande d'interrupteur mis en oeuvre par le circuit de commande 200 de la figure 2, selon un mode de réalisation. Plus précisément, on a représenté, en fonction du temps t, des exemples d'allures des signaux S321, S322 et S323 produits par le générateur 320 dans l'exemple du module 220 de la figure 3.

Dans cet exemple, les signaux S322 et S321 présentent entre eux un premier déphasage, et les signaux S323 et S321 présentent entre eux un deuxième déphasage double, ou sensiblement double, du premier déphasage. A titre d'exemple, les signaux S323 et S322 sont en avance sur le signal S321.

Les premier et deuxième déphasages sont de préférence supérieurs à 10 degrés, d'où il résulte que le déphasage entre les signaux S2-2 et S2-3 (figures 2 et 3) est supérieur, en valeur absolue, à 10 degrés. Par rapport à des valeurs plus faibles du déphasage, ceci permet de faciliter la mesure du déphasage entre les signaux S2-2 et S2-3 et, donc, l'obtention de l'état souhaité de l'interrupteur TH (figure 2). Dans l'exemple représenté, les premier et deuxième déphasages sont égaux respectivement à π/3 et 2π/3. Dans un autre exemple, les premier et deuxième déphasages peuvent être égaux respectivement à π/6 et π/3. Les premier et deuxième déphasages sont inférieurs à π, ce qui permet de distinguer une avance de phase d'un retard de phase.

Dans chacun des signaux S321, S322 et S323, la durée de l'état haut à chaque cycle est, de préférence, sensiblement égale à celle de l'état bas, par exemple égale à celle de l'état bas. Autrement dit, les signaux S2-i ont chacun, en dehors des changements d'état de la bascule 310, un rapport cyclique de préférence égal à environ 0,5, par exemple égal à 0,5.

De préférence, les déphasages et les rapports cycliques des signaux S321, S322 et S323 sont choisis de sorte que le signal S321 soit à un même premier niveau (le niveau bas dans l'exemple représenté) lors des fronts montants des signaux S322 et S323, et à un même deuxième niveau (le niveau haut dans l'exemple représenté) lors des fronts descendants des signaux S322 et S323. Ceci est obtenu, par exemple, avec les rapports cycliques égaux à 0,5 et les premiers et deuxièmes déphasages inférieurs à π. Il en résulte que le signal S2-1 est au premier niveau lors des fronts montants des signaux S2-2 et S2-3, et au deuxième niveau lors des fronts descendants des signaux S2-2 et S2-3.

La figure 5 représente, de manière schématique, un exemple d'un mode de réalisation du module 210 du circuit de commande 200 de la figure 2.

Le module 210 reçoit les signaux S3-i. Dans l'exemple représenté, le signal S3-1 est reçu sur l'entrée d'un inverseur 411 dont la sortie est reliée, de préférence connectée, à l'entrée d'un inverseur 412. Dans cet exemple, le signal S3-1 est, en outre, reçu sur l'entrée d'un inverseur 413 dont la sortie est reliée, de préférence connectée, à l'entrée d'un inverseur 414. Les inverseurs 412 et 414 fournissent un même signal S4-1 référencé au potentiel REFH (non représenté en figure 5). Encore dans cet exemple, le signal S3-2 est reçu sur l'entrée d'un inverseur 415 dont la sortie est reliée, de préférence connectée, à l'entrée d'un inverseur 416. Le signal S3-3 peut être reçu sur l'entrée d'un inverseur 417 dont la sortie est reliée, de préférence connectée, à l'entrée d'un inverseur 418. Dans cet exemple, les inverseurs 416 et 418 fournissent des signaux respectifs S4-2 et S4-3 référencés au potentiel REFH.

Ainsi, chaque signal S3-i est reçu par un couple d'inverseurs en série qui fournit un signal S4-i. Chaque signal S4-i prend le niveau logique du signal S3-i correspondant, en l'absence d'erreur de transmission du signal S3-i par la liaison 240-i.

En variante, on peut omettre un ou plusieurs des couples d'inverseurs 411 et 412, 413 et 414, 415 et 416, et 417 et 418, et remplacer chacun des couples omis par une connexion directe. Cependant, par rapport à cette variante, les inverseurs permettent de limiter les valeurs de tension prises par ces signaux à deux valeurs de tension correspondant aux niveaux logiques de ces signaux, ce qui simplifie la mise en oeuvre de l'étape d'obtention de l'état souhaité de l'interrupteur TH (non représenté en figure 5), mise en oeuvre par les éléments du module 210 décrits ci-après.

Le module 210 peut comprendre une porte OU EXCLUSIF, appelée aussi porte XOR, 422. La porte XOR 422 a deux entrées reliées, de préférence connectées, aux sorties des inverseurs respectifs 412 et 416. Autrement dit, la porte XOR 422 reçoit les signaux S4-1 et S4-2.

Le module 210 peut comprendre une bascule 432 de type D. L'entrée D de la bascule 432 est reliée, de préférence connectée, à la sortie de l'inverseur 416. Autrement dit, l'entrée D de la bascule 432 reçoit le signal S4-2. L'entrée d'horloge de la bascule 432 est reliée, de préférence connectée, à la sortie de la porte XOR 422.

Le module 210 peut comprendre une porte XOR 423. La porte XOR 423 a deux entrées reliées, de préférence connectées, aux sorties des inverseurs respectifs 414 et 418. Autrement dit, la porte XOR 423 reçoit les signaux S4-1 et S4-3.

Le module 210 peut comprendre une bascule 433 de type D. L'entrée D de la bascule 433 est reliée, de préférence connectée, à la sortie de l'inverseur 418. Autrement dit, l'entrée D de la bascule 433 reçoit le signal S4-3. L'entrée d'horloge de la bascule 433 est reliée, de préférence connectée, à la sortie de la porte XOR 423.

Le module 210 peut comprendre une bascule 440 de type D. L'entrée D de la bascule 440 est reliée, de préférence connectée, à la sortie Q de la bascule 433. L'entrée d'horloge de la bascule 440 est reliée, de préférence connectée, à la sortie Q de la bascule 432. La sortie Q de la bascule 440 fournit le signal de commande S1 à appliquer à l'interrupteur TH.

Bien que ceci ne soit pas représenté, les portes XOR 422 et 423, les bascules 432, 433 et 440, et les inverseurs 411, 412, 413, 414, 415, 416, 417 et 418 sont alimentés par la tension VDDH (figure 2) référencée au potentiel REFH.

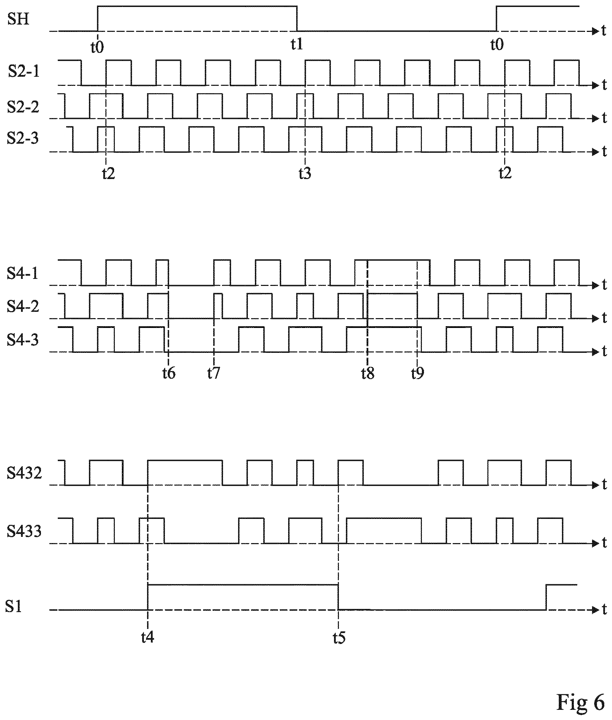

Le fonctionnement du module 210 est décrit ci-après, en relation avec la figure 6, dans l'exemple de la figure 4 de fonctionnement du module 220.

La figure 6 représente, sous forme de chronogrammes schématiques, des allures de signaux dans un exemple de mode de réalisation d'un procédé de commande d'interrupteur mis en oeuvre par le circuit de commande 200 de la figure 2. Dans cet exemple, les modules 210 et 220 du circuit de commande 200 correspondent aux exemples décrits ci-dessus en relation avec les figures 3, 4 et 5.

On a représenté les allures en fonction du temps t :
- du signal SH de commande reçu par le module 220 ;
- des signaux S2-1, S2-2, et S2-3 fournis par le module 220 ;
- des signaux S4-1, S4-2, et S4-3, correspondant aux signaux respectifs S3-1, S3-2 et S3-3 après leur réception par le module 210 ;
- des signaux S432 et S433 fournis par les sorties Q des bascules respectives 432 et 433 ; et
- du signal S1 de commande fourni par le module 210.

Dans l'exemple représenté, les signaux S3-1, S3-2 et S3-3 ont une fréquence égale à 8 fois la fréquence de découpage (celle du signal SH), ce qui est inférieur aux fréquences préférées décrites ci-dessus pour les signaux S3-1, S3-2 et S3-3, afin d'améliorer la lisibilité de la figure 6.

Le signal SH bascule de son niveau bas à son niveau haut à des instants t0, et de son niveau haut à son niveau bas à des instants t1. Dans l'exemple représenté, le rapport cyclique du signal SH, défini par le rapport entre la durée pendant laquelle le signal SH est à son niveau haut à chaque cycle de découpage, et la durée d'un cycle de découpage, est égal à environ 0,5. Ceci n'est pas limitatif, le rapport cyclique pouvant prendre toute valeur comprise entre 0 et 1.

Après chaque instant t0, à un instant t2, le signal S3-1 présente un front montant entre son état bas et son état haut. Plus précisément, l'instant t2 est, parmi les instants des fronts montants du signal S3-1 situés après l'instant t0, celui qui est le plus proche de cet instant t0. De manière similaire, après chaque instant t1, à un instant t3, le signal S3-1 présente un autre front montant. L'instant t3 est, parmi les instants des fronts montants du signal S3-1 situés après l'instant t1, celui qui est le plus proche de cet instant t1.

Entre chaque instant t2 et l'instant t3 suivant, le signal S3-2 est en retard de phase sur le signal S3-3. Entre chaque instant t3 et l'instant t2 suivant, le signal S3-2 est en avance de phase sur le signal S3-3.

Comme mentionné ci-dessus, en l'absence d'erreur de transmission entre les modules 220 et 210, les signaux S4-1, S4-2 et S4-3 sont aux mêmes niveaux logiques que les signaux respectifs S3-1, S3-2 et S3-3, à des délais de propagation près non représentés.

Comme mentionné ci-dessus, le signal S3-1 est à son niveau bas lors des fronts montants des signaux S3-2 et S3-3, et à son niveau haut lors des fronts descendants des signaux S3-2 et S3-3. Il en résulte que, à chacun des fronts montant et descendants des signaux S3-2 et S3-3, en l'absence d'erreur de transmission entre les modules 220 et 210, la porte XOR concernée 422, 423 présente un front montant à sa sortie. Par conséquent, en l'absence d'erreur de transmission, et à des délais de propagation près non représentés, les signaux S432 et S433 sont aux mêmes niveaux logiques que les signaux respectifs S3-2 et S3-3.

Après chaque instant t2, le signal S432 présente un front montant à un instant t4. Du fait que le signal S3-3 est en avance de phase sur le signal S3-2, le signal S433 est à son niveau haut à l'instant t4, et le signal S1 passe donc à son niveau haut.

Après chaque instant t3, le signal S432 présente un front montant à un instant t5. Du fait que le signal S3-3 est en retard de phase sur le signal S3-2, le signal S433 est à son niveau bas à l'instant t5, et le signal S1 passe donc à son niveau bas.

Ainsi, à chaque front montant du signal S432, le niveau du signal S433 est représentatif du signe du déphasage entre les signaux S432 et S433. A chaque front montant du signal S432, la bascule 440 mémorise le signe du déphasage. Cette valeur mémorisée est maintenue entre les fronts montants. On a ainsi mesuré le signe du déphasage, et le niveau du signal S1 correspond au signe mesuré. Il en résulte que le niveau du signal S1 est représentatif de l'état souhaité de l'interrupteur TH.

On peut remplacer la bascule 440 par tout circuit apte à mémoriser le niveau d'un premier signal (tel que le signal S433) à des instants auxquels ce niveau est représentatif de l'état souhaité de l'interrupteur TH, et, en dehors de ces instants, à donner au signal S1 le niveau mémorisé. Ces instants peuvent correspondre à tout basculement, tels que des fronts montants ou descendants, d'un deuxième signal (tel que le signal S432) entre deux niveaux de ce deuxième signal.

A partir de l'instant t4, l'interrupteur TH est mis à l'état passant. L'interrupteur TH est pleinement passant à un instant postérieur à l'instant t4. Une variation rapide, telle que définie ci-dessus, entre les potentiels REFH et REFO (figure 2), provoquée par la mise à l'état passant de l'interrupteur TH, est susceptible de se produire entre des instants t6 et t7. Cette variation rapide est susceptible de provoquer une erreur dans la transmission des signaux S3-i entre les modules 220 et 210 (figure 2). Typiquement, entre les instants t6 et t7, les signaux S4-i sont au niveau bas.

De manière similaire, après l'instant t5, l'interrupteur TH est mis à l'état bloqué, et une erreur de transmission des signaux S3-i est susceptible de se produire entre des instants t8 et t9. Typiquement, entre les instants t8 et t9, les signaux S4-i restent au niveau haut.

Ainsi, entre les instants t5 et t6, et entre les instants t8 et t9, les déphasages que l'on pourrait mesurer entre les signaux S4-2 et S4-3 ne sont pas représentatifs de l'état souhaité de l'interrupteur TH. Autrement dit, le déphasage entre les signaux S4-2 et S4-3 est à un état non valide entre les instants t5 et t6 et entre les instants t8 et t9. Ce déphasage est à un état valide lorsque la transmission des signaux S3-i est effectuée sans erreur.

Pour chacun des signaux S4-2 et S4-3, la porte XOR concernée, respectivement 422, 423, compare ce signal S4-2, S4-3 au signal S4-1. Entre les instants t6 et t7, et entre les instants t8 et t9, pour chacun des signaux S4-2 et S4-3, le résultat de la comparaison montre que le niveau ce signal S4-2, S4-3 et celui du signal S4-1 sont les mêmes. La porte XOR, respectivement 422, 423, ne fournit donc pas de front à l'entrée d'horloge de la bascule respective 432, 433. La bascule, respectivement 432, 433, conserve le niveau mémorisé avant l'instant t6 ou t8 du signal respectif S4-2, S4-3. La bascule respective 432, 433 maintient les signaux respectifs S432, S433 au niveau mémorisé tant que les résultats des comparaisons des signaux S4-2 et S4-3 au signal S4-1 correspondent à un état non valide du déphasage entre les signaux S4-2 et S4-3.

Ainsi, lorsque le déphasage est à un état non valide, aucun front n'est reçu par l'entrée d'horloge de la bascule 440. Le signal S1, appliqué à l'interrupteur TH, reste au niveau mémorisé par la bascule 440. Ainsi, même lorsque le déphasage entre les signaux S4-2 et S4-3 est à un état non valide, le niveau du signal S1 est représentatif de l'état souhaité de l'interrupteur TH.

Dans l'exemple décrit ci-dessus, les comparaisons des signaux S4-2 et S4-3 avec le signal S4-1 sont effectuées par des portes XOR. Ceci n'est pas limitatif, un état du déphasage entre les signaux S4-2 et S4-3 peut être déterminé parmi les états valide et non valide de n'importe quelle manière, par exemple en fonction du résultat de toute comparaison des signaux S4-2 et S4-3 avec le signal S4-1 permettant de détecter une erreur de transmission des signaux S4-i.

Dans l'exemple décrit ci-dessus, les bascules 432 et 433 ont pour fonction de mémoriser les niveaux pris par les signaux S4-2 et S4-3 lorsque leur déphasage est à l'état valide, et de maintenir les niveaux de ces signaux aux niveaux mémorisés lorsque le déphasage est à l'état non valide. Cependant, les bascules 432 et 433 peuvent être remplacées par tout circuit apte à remplir cette fonction.

On a décrit ci-dessus un exemple particulier du module 210 mettant en oeuvre :
- lorsque le déphasage entre les signaux S4-2 et S4-3 est à l'état valide, la mémorisation d'une valeur représentative de l'état souhaité de l'interrupteur TH ; et
- lorsque le déphasage entre les signaux S4-2 et S4-3 est à un état non valide, la fourniture de la valeur mémorisée à appliquer à l'interrupteur TH.
Cet exemple n'est pas limitatif, et le module 210 peut être tout circuit apte, lorsqu'un déphasage est à un état valide, à mémoriser une valeur de ce déphasage, et, lorsque ce déphasage est à un état non valide, à fournir cette valeur.

Dans une variante, le signal S3-1, les inverseurs 411, 412, 413, et 414, les portes XOR 422 et 423, et les bascules 432 et 433 sont omis. La bascule 440 reçoit directement le signal S4-3 sur son entrée D et le signal S3-3 sur son entrée d'horloge. Cette variante peut être mise en oeuvre lorsque les variations des potentiels REFH et REFO l'un par rapport à l'autre sont suffisamment lentes pour que la transmission des signaux entre les modules 220 et 210 soit effectuée sans erreur.

Par rapport à cette variante, le fait de prévoir le signal S3-1 permet de déterminer l'état valide/non valide du déphasage entre les signaux S3-2 et S3-3, et permet d'appliquer à l'interrupteur TH une valeur représentative de l'état souhaité même lorsque des erreurs se produisent au cours de la transmission entre les modules 220 et 210. On peut ainsi augmenter la vitesse de commutation de l'interrupteur TH sans risque que la commande appliquée à l'interrupteur TH soit temporairement à un niveau non souhaité. Ceci permet donc, par rapport à des convertisseurs connus, d'accélérer la fréquence de découpage et/ou d'augmenter le niveau de fiabilité. Selon un avantage, plus la fréquence de découpage est élevée, plus le convertisseur peut être compact et/ou avoir un rendement énergétique élevé.

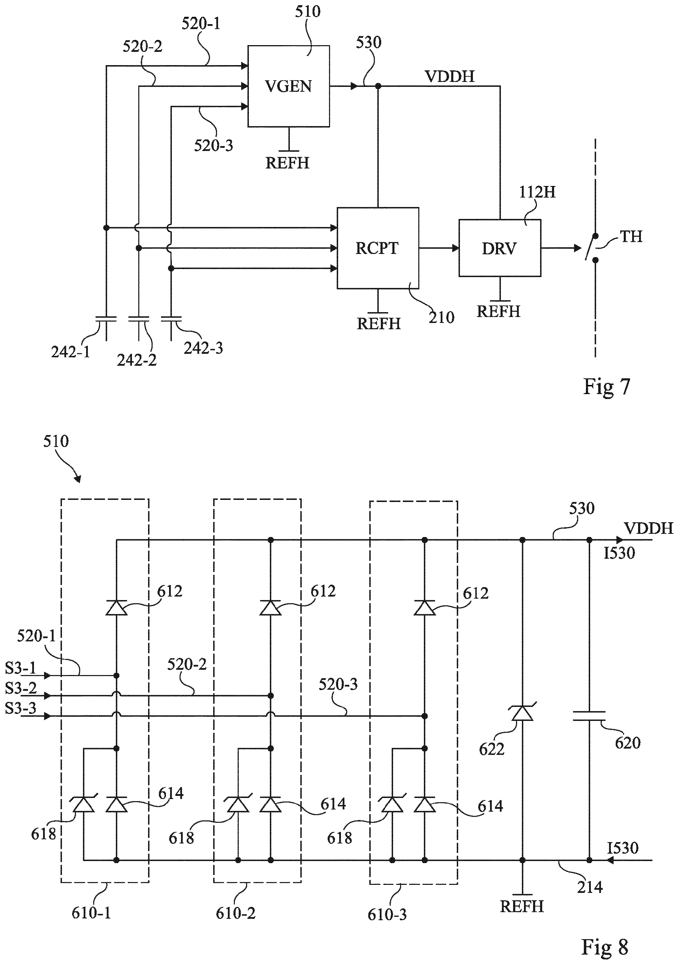

La figure 7 représente, de manière schématique, un exemple d'un mode de réalisation d'encore une autre partie du circuit de commande 200 de la figure 2. Plus précisément, on a représenté le module 210, le circuit de commande rapprochée 112H, l'interrupteur TH, et les éléments capacitifs 242-i (242-1, 242-2, 242-3) reliés au module 210.

Le circuit de commande 200 comprend un générateur de tension 510 (VGEN). Le générateur 510 fournit la tension VDDH référencée au potentiel REFH qui alimente le module 210 et qui, de préférence, alimente également le circuit de commande rapprochée 112H.

Selon le présent mode de réalisation, le générateur 510 reçoit, sur des entrées respectives 520-i (520-1, 520-2, 520-3), les signaux S3-i, ou un ou plusieurs des signaux S3-i, après leur transmission par les éléments capacitifs 242-i. Le générateur 510 utilise une énergie véhiculée par les signaux S3-i qu'il reçoit pour produire la tension VDDH sur une sortie 530.

Lors du démarrage du convertisseur, l'application des signaux S3-i suffit à fournir la tension VDDH permettant la mise à l'état passant de l'interrupteur TH. Le convertisseur est donc, avantageusement, démarré de manière particulièrement simple.

Le circuit de commande 200 selon le présent mode de réalisation transmet avantageusement aux circuits 210 (RCPT) et 112H, qui appliquent la commande souhaitée à l'interrupteur TH, à la fois, le niveau du signal SH de commande de l'interrupteur TH (transmis de la manière décrite ci-dessus en relation avec les figures 2 à 6) et l'énergie permettant d'alimenter ces circuits 210 et 112H.

La figure 8 représente, de manière schématique, un exemple du générateur 510 du mode de réalisation de la figure 7.

De préférence, le générateur 510 comprend un circuit redresseur. Plus préférentiellement, le générateur 510 comprend un circuit redresseur 610-i pour chacun des signaux S3-i, à savoir, dans l'exemple représenté, trois circuits redresseurs 610-1, 610-2, 610-3 pour les trois signaux respectifs S3-1, S3-2 et S3-3.

Chaque circuit redresseur 610-i comprend deux diodes 612, 614 électriquement en série entre le noeud 214 d'application du potentiel de référence REFH et la sortie 530 du générateur 510. Le signal S3-i est reçu sur un noeud de connexion en série des diodes 612 et 614, ce noeud constituant l'entrée 520-i du générateur 510. La diode 612 est située du côté de la sortie 530. Les diodes 612 et 614 ont leurs cathodes tournées vers la sortie 530.

Le générateur 510 comprend en outre un élément capacitif 620 reliant la sortie 530 au noeud 214 d'application du potentiel REFH. L'élément capacitif 620 peut comprendre un ou plusieurs condensateurs en parallèle.

La tension VDDH, référencée par rapport au potentiel REFH et fournie par les circuits redresseurs 610-i, peut être égale à une différence de potentiel entre les états haut et bas des signaux S3-i, à des chutes de tension près dans les diodes 612 et 614. Autrement dit, la tension VDDH peut être égale à l'amplitude des variations de tension présentées par les signaux S3-i, à des tensions de seuil de diode près. De préférence, cette amplitude est comprise entre 3 V et 12 V, par exemple de l'ordre de 6 V.

L'élément capacitif 620 a une valeur de capacité suffisante pour limiter les ondulations résiduelles de la tension VDDH à la fréquence des signaux S3-i. A titre d'exemple, la valeur de capacité de l'élément capacitif 620 est comprise entre 0,1 nF et 10 nF, par exemple est de l'ordre de 1 nF. L'amplitude des ondulations résiduelles peut être calculée d'une manière usuellement mise en oeuvre pour calculer les ondulations de tension d'un circuit redresseur.

Selon un avantage, les diodes 614 permettent, lorsque le potentiel REFH croît par rapport au potentiel REFO, de charger les éléments capacitifs 242-i. Ceci peut également être obtenu, en l'absence du générateur 510, par tout dispositif apte à charger les éléments capacitifs 242-i.

Selon un autre avantage, le module 210 et le circuit de commande rapprochée 112H prélèvent un courant I530 sur la sortie 530. Par rapport à des modes de réalisation dans lesquels le générateur 510 est omis, ceci permet de décharger plus rapidement les éléments capacitifs 242-i (figure 7) lorsque le potentiel REFH décroît par rapport au potentiel REFO (figure 2) . Ceci permet de limiter la durée entre les instants t6 et t7 (figure 6) pendant laquelle une erreur risque de se produire dans la transmission des signaux S3-i. Ceci peut également être obtenu, en l'absence ou en complément du générateur 510, par tout dispositif apte à décharger les éléments capacitifs entre les instants t6 et t7.

De préférence, chaque circuit redresseur comprend une diode Zener 618 reliant l'entrée 520-i concernée au noeud 214 d'application du potentiel de référence REFH. Dans chaque circuit redresseur, la cathode de la diode Zener 618 est tournée vers l'entrée 520-i. En complément ou en remplacement des diodes Zener 618, on peut prévoir une diode Zener 622 électriquement en parallèle de l'élément capacitif 620, la cathode de la diode Zener 622 étant tournée vers la sortie 530. Lorsque le potentiel REFH diminue par rapport au potentiel REFO, les diodes Zener 618 et/ou 622 permettent de décharger les éléments capacitifs 242-i. Ceci permet, comme mentionné ci-dessus, de réduire la durée pendant laquelle une erreur peut se produire pendant la transmission des signaux S3-i.

En outre, les diodes Zener 618 et/ou 622 permettent, lorsque le potentiel REFH diminue par rapport au potentiel REFO, que la tension VDDH reste inférieure à un seuil donné de tension. De préférence, ce seuil est supérieur à l'amplitude des variations de tension des signaux S3-i. Autrement dit, les diodes Zener 618 et/ou 622 constituent un circuit d'écrêtage de la tension VDDH et, de préférence, des tensions des signaux S3-i reçus après leur transmission par les éléments capacitifs 242-i.

La durée entre les instants t6 et t7 peut être calculée, à partir des indications ci-dessus, en utilisant tout procédé usuel de calcul de décharge d'un condensateur. En particulier, dans le cas où le courant I530 présente, en fonction du temps, des variations liées au fonctionnement des circuits alimentés par la tension VDDH, ce calcul peut être effectué au moyen de tout outil de simulation par ordinateur. De préférence, on choisit des valeurs de capacité des éléments capacitifs 242-i en fonction du courant I530 et des variations entre potentiels REFH et REFO de telle sorte que la durée calculée entre les instants t8 et t7 soit très inférieure à la durée d'un cycle de découpage, c'est-à-dire qu'elle soit plus de 5 fois plus faible, de préférence plus de 10 fois plus faible, que la durée d'un cycle de découpage. De préférence, les éléments capacitifs 242-i ont la même valeur de capacité, ou sensiblement la même valeur de capacité, typiquement comprise entre 20 pF et 500 pF, par exemple égale à environ 100 pF.

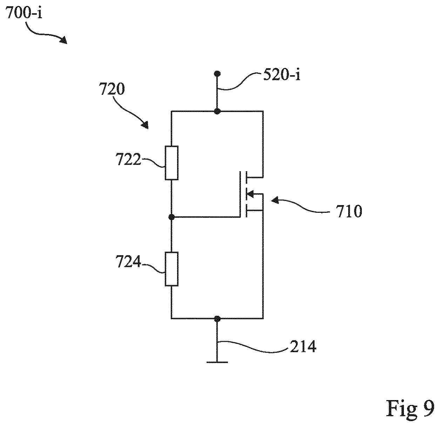

La figure 9 représente, de manière schématique, un circuit 700-i d'une variante de réalisation du générateur 510.

Le circuit 700-i relie l'une des entrées 520-i au noeud 214 d'application du potentiel de référence REFH. Dans l'exemple du générateur 510 de la figure 8, chaque entrée 520-i peut être reliée au noeud 214 par un circuit 700-i identique ou similaire à celui représenté. Chacune des diodes Zener 618 du générateur 510 de la figure 8 peut être électriquement en parallèle du circuit 700-i ou être remplacée par le circuit 700-i.

Le circuit 700-i comprend un transistor 710, par exemple de type à effet de champ à canal N, et un pont diviseur 720 reliant l'entrée 520-i au noeud 214 d'application du potentiel de référence. Le pont diviseur 702 peut comprendre deux éléments résistifs 722, 724 électriquement en série entre l'entrée 520-i et le noeud 214. Le transistor 710 peut avoir une borne de drain reliée à l'entrée 520-i et une borne de source reliée au noeud 214. Le transistor 710 peut avoir une borne de commande, par exemple une borne de grille, reliée, de préférence connectée, à un noeud de connexion en série des éléments résistifs 722 et 724. Autrement dit le pont diviseur reçoit le signal S3-i et commande le transistor 710.

Le rapport entre valeurs des résistances 722 et 724 est choisi pour que le transistor 710 devienne passant lorsque la tension entre l'entrée 520-i et le noeud 214 devient supérieure à un seuil. Ainsi, le circuit 700-i peut constituer tout ou partie d'un circuit d'écrêtage, en complément ou en remplacement des diodes Zener 618.

Les résistances 722 et 724 présentent en outre l'avantage, lorsque le potentiel REFH diminue par rapport au potentiel REFO, de décharger l'élément capacitif 242-i concerné. Les valeurs des résistances 722 et 724 peuvent être choisies en sorte de limiter la durée pendant laquelle une erreur de transmission des signaux S2-i risque de se produire (entre les instants t6 et t7, figure 6).

Un avantage des modes de réalisation décrits est qu'il est désormais possible de détecter un état non-valide des signaux de commande reçus par le module 210 en raison notamment de variations des potentiels de référence entre les circuit amont et aval des capacités de découplage. De plus, non seulement, on effectue cette détection mais elle ne nuit pas au fonctionnement du convertisseur dans la mesure où l'on utilise alors un (le dernier) état valide mémorisé.

Un autre avantage des modes de réalisation décrits est que les signaux de commande déphasés véhiculent, non seulement l'information représentative de l'état ouvert ou fermé à donner à l'interrupteur TH, mais également l'énergie du module 210 et du circuit 112H.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de commande d'au moins un interrupteur (TH), comprenant :
- la fourniture, par un module émetteur (220) et à partir d'un premier signal (SH) en créneaux, représentatif de l'état souhaité dudit interrupteur et dont des cycles se répètent à une fréquence de découpage, de deuxièmes signaux (S2-i) en créneaux ayant tous une même fréquence, supérieure à la fréquence de découpage, lesdits deuxièmes signaux ayant entre eux au moins un déphasage dont la valeur est fonction de l'état du premier signal ;
- la transmission desdits deuxièmes signaux à travers des éléments capacitifs (242-i) fournissant des signaux déphasés ;
- la réception, par un module récepteur (210), des signaux déphasés (S3-i) reproduisant ledit au moins un déphasage ;
- la vérification, par le module récepteur (210), d'un état valide ou invalide dudit au moins un déphasage, un état valide correspondant à une transmission sans erreur des signaux déphasés (S3-i) à travers les éléments capacitifs (242-i) ;
- l'obtention et la mémorisation, lorsque l'état dudit au moins un déphasage est valide, d'une valeur (S1) à partir desdits signaux déphasés, ladite valeur (S1) étant représentative de l'état souhaité dudit au moins un interrupteur ; et
- l'application, audit au moins un interrupteur, de la valeur représentative obtenue si l'état dudit au moins un déphasage est valide ou de la valeur représentative mémorisée si l'état dudit au moins un déphasage est invalide.

2. Procédé selon la revendication 1, dans lequel l'état valide ou invalide est déterminé en comparant un premier signal déphasé (S3-1) respectivement à un deuxième (S3-2) et un troisième (S3-3) signal déphasé.

3. Procédé selon la revendication 1 ou 2, dans lequel ledit module émetteur (220) est référencé à un premier potentiel (REFO), ledit module récepteur (210) étant référencé à un deuxième potentiel (REFH) variable par rapport au premier potentiel.

4. Procédé selon la revendication 3, dans lequel le deuxième potentiel (REFH) est un potentiel de référence de commande dudit au moins un interrupteur (TH).

5. Procédé selon l'une quelconque des revendications 1 à 4, dans lequel un générateur (510) d'une tension (VDDH) utilise une énergie véhiculée par lesdits signaux (S3-i), le générateur comprenant, de préférence, un circuit redresseur (610-i).

6. Procédé selon la revendication 5, dans lequel ledit module récepteur (210, 112H) est alimenté par ladite tension (VDDH).

7. Procédé selon la revendication 5 ou 6, dans lequel le générateur (510) comprend un circuit d'écrêtage (618, 622 ; 700-i), de préférence comprenant une ou plusieurs diodes Zener (618, 622) et/ou un ou plusieurs transistors (710) commandés par des ponts diviseurs (720) recevant lesdits signaux (S3-i).

8. Circuit (250) de commande d'au moins un interrupteur (TH) comportant :
- au moins un circuit de commande rapprochée (112H) d'application, à une borne de commande dudit au moins un interrupteur, d'un signal de commande (OUT) en créneaux dont des cycles se répètent à une fréquence de découpage ; et
- un module récepteur (210) de signaux déphasés (S3-1) en créneaux, représentatifs d'un état souhaité dudit au moins un interrupteur, la fréquence des cycles desdits signaux déphasés étant supérieure à la fréquence de découpage et au moins un déphasage entre lesdits signaux déphasés étant d'une valeur différente en fonction de l'état souhaité dudit au moins un interrupteur, le module récepteur fournissant, audit circuit de commande rapprochée, une valeur (S1) correspondant à une valeur obtenue et mémorisée à partir dudit au moins un déphasage lorsque l'état dudit au moins un déphasage est valide et à une valeur mémorisée si l'état dudit au moins un déphasage est invalide, un état valide correspondant à une transmission sans erreur des signaux déphasés (S3-i) à travers les éléments capacitifs (242-i).

9. Circuit selon la revendication 8, dans lequel l'état valide ou invalide est déterminé en comparant un premier signal déphasé (S3-1) respectivement à un deuxième (S3-2) et un troisième (S3-3) signal déphasé.

10. Circuit selon la revendication 8 ou 9, comportant un générateur (510) d'une tension (VDDH) à partir d'une énergie véhiculée par lesdits signaux déphasés (S3-i), le générateur comprenant un circuit d'écrêtage (618, 622 ; 700-i) desdits signaux déphasés (S3-i) .

11. Circuit selon l'une quelconque des revendications 8 à 10, comportant deux portes logiques (422, 423), réalisant chacune une fonction de type OU-Exclusif, comparant un premier signal déphasé (S3-1) respectivement à un deuxième (S3-2) et un troisième (S3-3) signal déphasé, l'état valide ou non valide dudit au moins un déphasage étant déterminé en fonction de résultats des comparaisons.

12. Circuit selon la revendication 11, comportant en outre :
- une première et une deuxième bascule (432, 433) ayant des entrées de données recevant respectivement lesdits deuxième et troisième signaux déphasés (S3-2, S3-3) et des entrées d'horloge recevant les résultats respectifs des comparaisons opérées par lesdites portes logiques (422, 423) ; et
- une troisième bascule (440) de fourniture de ladite valeur représentative (S1) de l'état souhaité dudit au moins un interrupteur, la troisième bascule (440) ayant une entrée d'horloge reliée à une sortie de la deuxième bascule et une entrée de donnée reliée à une sortie de la troisième bascule.

13. Système de commande d'au moins un interrupteur (TH) comportant :
- un module émetteur (220) de fourniture, à partir d'un premier signal (SH) en créneaux représentatif de l'état souhaité dudit interrupteur et dont des cycles se répètent à une fréquence de découpage, de deuxièmes signaux (S2-i) en créneaux ayant tous une même fréquence, supérieure à la fréquence de découpage, lesdits deuxièmes signaux ayant entre eux au moins un déphasage d'une valeur différente en fonction de l'état du premier signal ;
- un circuit de commande (250) selon l'une quelconque des revendications 8 à 12 ; et
- des élément capacitifs (242-i) de transmission desdits deuxièmes signaux audit circuit de commande sous la forme desdits signaux déphasés.

14. Système selon la revendication 13, configuré pour mettre en oeuvre un procédé selon l'une quelconque des revendications 1 à 7.

15. Dispositif comprenant un système selon la revendication 13 ou 14 et ledit au moins un interrupteur (TH), ledit au moins un interrupteur étant de préférence de type HEMT, plus préférentiellement à GaN.

16. Dispositif monolithique comprenant un circuit selon l'une quelconque des revendications 8 à 12 ou un dispositif selon la revendication 15.

17. Convertisseur à découpage comprenant un ou plusieurs systèmes selon la revendication 13 ou 14, et/ou un ou plusieurs dispositifs selon la revendication 15 ou 16.

## Patentansprüche

1. Verfahren zum Steuern mindestens eines Schalters (TH), aufweisend:
- Liefern durch ein Sendemodul (220) und ausgehend von einem ersten Rechteckimpulssignal (SH), das für den gewünschten Zustand des Schalters repräsentativ ist und dessen Zyklen sich mit einer Schaltfrequenz wiederholen, zweite Rechteckimpulssignale (S2-i), die alle eine gleiche Frequenz aufweisen, die höher ist als die Schaltfrequenz, wobei die zweiten Signale zwischen sich mindestens eine Phasenverschiebung aufweisen, deren Wert vom Zustand des ersten Signals abhängt;
- Übertragen der zweiten Signale durch kapazitive Elemente (242-i), die phasenverschobene Signale liefern;
- Empfangen, durch ein Empfängermodul (210), von phasenverschobenen Signalen (S3-i) die die mindestens eine Phasenverschiebung wiedergeben;
- Verifizieren, durch das Empfängermodul (210), eines gültigen oder ungültigen Zustands der mindestens einen Phasenverschiebung, wobei ein gültiger Zustand einer fehlerfreien Übertragung der phasenverschobenen Signale (S3-i) durch die kapazitiven Elemente (242-i) entspricht;
- Erhalten und Speichern, wenn der Zustand der mindestens einen Phasenverschiebung gültig ist, eines Wertes (S1) aus den phasenverschobenen Signalen, wobei der Wert (S1) den gewünschten Zustand des mindestens einen Schalters darstellt; und
- Anlegen, an den mindestens einen Schalter, des repräsentativen Wertes, der erhalten wird, wenn der Zustand der mindestens einen Phasenverschiebung gültig ist, oder des gespeicherten repräsentativen Wertes, wenn der Zustand der mindestens einen Phasenverschiebung ungültig ist.

2. Verfahren nach Anspruch 1, wobei der gültige oder ungültige Zustand bestimmt wird durch Vergleich eines ersten phasenverschobenen Signals (S3-1) mit einem zweiten (S3-2) bzw. einem dritten (S3-3) phasenverschobenen Signal.

3. Verfahren nach Anspruch 1 oder 2, wobei das Sendemodul (220) auf ein erstes Potential (REFO) referenziert ist und das Empfängermodul (210) auf ein zweites Potential (REFH) referenziert ist, das bezüglich des ersten Potentials variabel ist.

4. Verfahren nach Anspruch 3, wobei das zweite Potenzial (REFH) ein Steuer-Referenzpotenzial des mindestens einen Schalters (TH) ist.

5. Verfahren nach einem der Ansprüche 1 bis 4, wobei ein Generator (510) einer Spannung (VDDH) die von den Signalen (S3-i) übertragene Leistung verwendet, wobei der Generator vorzugsweise eine Gleichrichterschaltung (610-i) umfasst.

6. Verfahren nach Anspruch 5, wobei das Empfängermodul (210, 112H) durch die Spannung (VDDH) betrieben wird.

7. Verfahren nach Anspruch 5 oder 6, wobei der Generator (510) eine Begrenzungsschaltung (618, 622; 700-i) aufweist, die vorzugsweise eine oder mehrere Zenerdioden (618, 622) und/oder einen oder mehrere Transistoren (710) aufweist, die von Teilerbrücken (720) gesteuert werden, die die Signale (S3-i) empfangen.

8. Schaltung (250) zum Steuern mindestens eines Schalters (TH), die Folgendes aufweist:
- mindestens eine Schließ-Steuerschaltung (112H) zum Anlegen eines Rechteckimpuls-Steuersignals (OUT), dessen Zyklen sich mit einer Schaltfrequenz wiederholen, an einen Steueranschluss des mindestens einen Schalters; und
- ein Empfängermodul (210) für phasenverschobene Rechteckimpulssignale (S3-1), die für einen gewünschten Zustand des mindestens einen Schalters repräsentativ sind, wobei die Frequenz der Zyklen der phasenverschobenen Signale größer als die Schaltfrequenz ist und mindestens eine Phasenverschiebung zwischen den phasenverschobenen Signalen einen unterschiedlichen Wert in Abhängigkeit vom gewünschten Zustand des mindestens einen Schalters aufweist, wobei das Empfängermodul einen Wert (S1) an die Schließ-Steuerschaltung liefert, der einem aus der mindestens einen Phasenverschiebung erhaltenen und gespeicherten Wert entspricht, wenn der Zustand der mindestens einen Phasenverschiebung gültig ist, und der einen gespeicherten Wert entspricht, wenn der Zustand der mindestens einen Phasenverschiebung ungültig ist, wobei ein gültiger Zustand einer fehlerfreien Übertragung der phasenverschobenen Signale (S3-i) durch die kapazitiven Elemente (242-i) entspricht.

9. Schaltung nach Anspruch 8, wobei der gültige oder ungültige Zustand durch Vergleich eines ersten phasenverschobenen Signals (S3-1) mit einem zweiten (S3-2) bzw. einem dritten (S3-3) phasenverschobenen Signal bestimmt wird.

10. Schaltung nach Anspruch 8 oder 9, die einen Generator (510) einer Spannung (VDDH) aus einer durch die phasenverschobenen Signale (S3-i) übertragenen Energie aufweist, wobei der Generator eine Schaltung zum Begrenzen (618, 622; 700-i) der phasenverschobenen Signale (S3-i) aufweist.

11. Schaltung nach einem der Ansprüche 8 bis 10, aufweisend zwei Logikgatter (422, 423), die jeweils eine Exklusiv-ODER-Funktion ausführen und ein erstes phasenverschobenes Signal (S3-1) mit einem zweiten (S3-2) bzw. einem dritten (S3-3) phasenverschobenen Signal vergleichen, wobei der gültige oder ungültige Zustand der mindestens einen Phasenverschiebung in Abhängigkeit von den Ergebnissen der Vergleiche bestimmt wird.

12. Schaltung nach Anspruch 11, ferner aufweisend:
- ein erstes und ein zweites Flip-Flop (432, 433) mit Dateneingängen, die das zweite bzw. dritte phasenverschobene Signal (S3-2, S3-3) empfangen, und Takteingängen, die die jeweiligen Ergebnisse der von den Logikgattern (422, 423) durchgeführten Vergleiche empfangen; und
- ein drittes Flip-Flop (440) zum Liefern des repräsentativen Werts (S1) des gewünschten Zustands des mindestens einen Schalters, wobei das dritte Flip-Flop (440) einen Takteingang aufweist, der mit einem Ausgang des zweiten Flip-Flops verbunden ist, und einen Dateneingang, der mit einem Ausgang des dritten Flip-Flops verbunden ist.

13. System zur Steuerung mindestens eines Schalters (TH) aufweisend:
- ein Sendemodul (220) zum Liefern, aus einem ersten Rechteckimpulssignal (SH), das für den gewünschten Zustand des Schalters repräsentativ ist und dessen Zyklen sich mit einer Schaltfrequenz wiederholen, von zweiten Rechteckimpulssignalen (S2-i), die alle eine gleiche Frequenz haben, die höher als die Schaltfrequenz ist, wobei die zweiten Signale zwischen sich mindestens eine Phasenverschiebung mit einem unterschiedlichen Wert in Abhängigkeit vom Zustand des ersten Signals aufweisen;
- eine Steuerschaltung (250) nach einem der Ansprüche 8 bis 12; und
- kapazitiven Elementen (242-i) zum Senden der zweiten Signale an die Steuerschaltung in Form der phasenverschobenen Signale.

14. System nach Anspruch 13, das konfiguriert ist zum Durchführen eines Verfahrens nach einem der Ansprüche 1 bis 7.

15. Vorrichtung, die ein System nach Anspruch 13 oder 14 und den mindestens einen Schalter (TH) aufweist, wobei der mindestens eine Schalter vorzugsweise vom HEMT-Typ, besonders bevorzugt vom GaN-Typ ist.

16. Monolithische Vorrichtung mit einer Schaltung nach einem der Ansprüche 8 bis 12 oder einer Vorrichtung nach Anspruch 15.

17. Schaltwandler mit einem oder mehreren Systemen nach Anspruch 13 oder 14 und/oder einer oder mehreren Vorrichtungen nach Anspruch 15 oder 16.

## Claims

1. Method for controlling at least one switch (TH), comprising:
- supplying, by a transmitter module (220) and from a first square pulse signal (SH), representative of the desired state of said switch and cycles of which are repeated at a switching frequency, second square pulse signals (S2-i) all having a same frequency, greater than the switching frequency, said second signals having between them at least one phase shift, the value of which depends on the state of the first signal;
- transmitting said second signals through capacitive elements (242-i) delivering phase-shifted signals;
- receiving, by a receiver module (210), phase-shifted signals (S3-i) reproducing said at least one phase shift;
- verifying, by the receiver module (210), a valid or invalid state of said at least one phase shift, a valid state corresponding to an error-free transmitting of the phase-shifted signals (S3-i) through the capacitive elements (242-i);
- obtaining and storing, when the state of said at least one phase shift is valid, a value (S1) from said phase-shifted signals, said value (S1) being representative of the desired state of said at least one switch; and
- applying, to said at least one switch, the representative value obtained if the state of said at least one phase shift is valid or the stored representative value if the state of said at least one phase shift is invalid.

2. Method according to claim 1, wherein the valid or invalid state is determined by comparing a first phase-shifted signal (S3-1) with a second (S3-2) and a third (S3-3) phase-shifted signal, respectively.

3. Method according to claim 1 or 2, wherein said transmitter module (220) is referenced to a first potential (REFO), said receiver module (210) being referenced to a second potential (REFH) variable with respect to the first potential.

4. Method according to claim 3, wherein the second potential (REFH) is a control reference potential of said at least one switch (TH).

5. Method according to any one of claims 1 to 4, wherein a generator (510) of a voltage (VDDH) uses power conveyed by said signals (S3-i), the generator preferably comprising a rectifier circuit (610-i).

6. Method according to claim 5, wherein said receiver module (210, 112H) is powered by said voltage (VDDH).

7. Method according to claim 5 or 6, wherein the generator (510) comprises a clipping circuit (618, 622; 700-i), preferably comprising one or more Zener diodes (618, 622), and/or one or more transistors (710) controlled by divider bridges (720) receiving said signals (S3-i).

8. Circuit (250) for controlling at least one switch (TH) comprising:
- at least one close control circuit (112H) for applying, to a control terminal of said at least one switch, a square pulse control signal (OUT) the cycles of which are repeated at a switching frequency; and
- a receiver module (210) for square pulse phase-shifted signals (S3-1), representative of a desired state of said at least one switch, the frequency of the cycles of said phase-shifted signals being greater than the switching frequency and at least one phase shift between said phase-shifted signals being of a different value depending on the desired state of said at least one switch, the receiver module supplying, to said close control circuit, a value (S1) corresponding to a value obtained and stored from said at least one phase shift when the state of said at least one phase shift is valid, and to a stored value if the state of said at least one phase shift is invalid, a valid state corresponding to an error-free transmitting of the phase-shifted signals (S3-i) through the capacitive elements (242-i).

9. Circuit according to claim 8, wherein the valid or invalid state is determined by comparing a first phase-shifted signal (S3-1) with a second (S3-2) and a third (S3-3) phase-shifted signal, respectively.

10. Circuit according to claim 8 or 9, including a generator (510) of a voltage (VDDH) from an energy conveyed by said phase-shifted signals (S3-i), the generator comprising a circuit for clipping (618, 622; 700-i) said phase-shifted signals (S3-i) .

11. Circuit according to any one of claims 8 to 10, including two logic gates (422, 423), each performing an Exclusive-OR type function, comparing a first phase-shifted signal (S3-1) with a second (S3-2) and a third (S3-3) phase-shifted signal respectively, the valid or invalid state of said at least one phase shift being determined according to the results of the comparisons.

12. Circuit according to claim 11, further comprising:
- a first and a second flip-flop (432, 433) having data inputs respectively receiving said second and third phase-shifted signals (S3-2, S3-3) respectively and clock inputs receiving the respective results of the comparisons operated by said logic gates (422, 423); and
- a third flip-flop (440) for supplying said representative value (S1) of the desired state of said at least one switch, the third flip-flop (440) having a clock input connected to an output of the second flip-flop and an input of data connected to an output of the third flip-flop.

13. System for controlling at least one switch (TH) including:
- a transmitter module (220) for supplying, from a first square pulse signal (SH) representative of the desired state of said switch and cycles of which are repeated at a switching frequency, second square pulse signals (S2-i) all having a same frequency, higher than the switching frequency, said second signals having between them at least one phase shift of a different value depending on the state of the first signal;
- a control circuit (250) according to any one of claims 8 to 12; and
- capacitive elements (242-i) for transmitting said second signals to said control circuit in the form of said phase-shifted signals.

14. System according to claim 13, configured to implement a method according to any one of claims 1 to 7.

15. Device comprising a system according to claim 13 or 14 and said at least one switch (TH), said at least one switch preferably being of HEMT type, more preferably of GaN type.

16. Monolithic device comprising a circuit according to any one of claims 8 to 12 or a device according to claim 15.

17. Switching converter comprising one or more systems according to claim 13 or 14, and/or one or more devices according to claim 15 or 16.
